# EUROPÄISCHE PATENTANMELDUNG

(11) **EP 1 209 742 A1**
(43) Veröffentlichungstag der Anmeldung: **29.05.2002**
(21) Anmeldenummer: 00811110.6
(22) Anmeldetag: 22.11.2000
(51) Int. Cl.: H01L 23/48, H01L 25/07

(54) **Hochleistungshalbleitermodul sowie Anwendung eines solchen Hochleistungshalbleitermoduls**

(71) Anmelder: ABB Schweiz AG, 5400 Baden (CH)
(72) Erfinder: Lang, Thomas, 8050 Zürich (CH)
(74) Vertreter: ABB Patent Attorneys

(57) **Zusammenfassung**

Ein Hochleistungshalbleitermodul (10) umfasst mehrere flächige Halbleiterchips (14), die mit der Unterseite unter Herstellung erster elektrischer Kontakte flächig auf einer Bodenplatte (11) aufliegen und auf der Oberseite von einer parallel zur Bodenplatte (11) angeordneten Deckplatte (13) unter Herstellung zweiter elektrischer Kontakte mit Druck beaufschlagt werden.

Bei einem solchen Modul wird eine vereinfachte Kühlung dadurch ermöglicht, dass die den Halbleiterchips (14) abgewandten Seiten bzw. Aussenseiten der Bodenplatte (11) und der Deckplatte (13) jeweils von den Halbleiterchips (14) elektrisch isoliert ausgebildet sind.

## Beschreibung

### TECHNISCHES GEBIET

Die vorliegende Erfindung bezieht sich auf das Gebiet der Leistungselektronik. Sie betrifft ein Hochleistungshalbleitermodul gemäss dem Oberbegriff des Anspruchs 1.

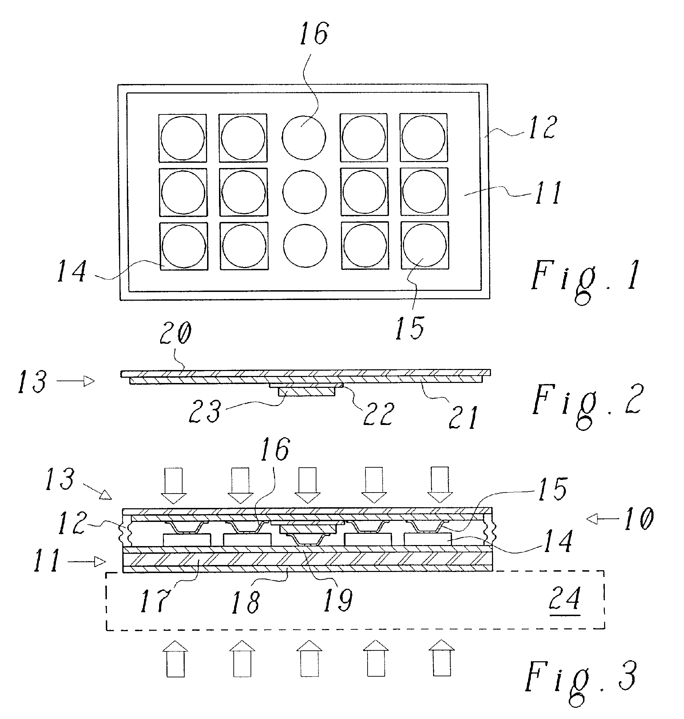

Ein solches Hochleistungshalbleitermodul ist z.B. aus einem Artikel von H. Zeller, "High Power Components - From the State of the Art to Future Trends", PCIM Nürnberg, Mai 1998 (Fig. 3), bekannt.

### STAND DER TECHNIK

Hochleistungshalbleitermodule sind in den unterschiedlichsten Ausbildungen aus dem Stand der Technik bekannt (siehe z.B. die EP-A1-0 597 144 oder die US-A-5,978,220 oder die US-A-6,087,682).

Hochleistungshalbleitermodule werden bei Spannungen bis zu 10 kV pro Modul betrieben. Durch Serieschaltung (z.B. bei Hochspannungs-GleichstromÜbertragung) werden Spannungen weit oberhalb 100 kV erreicht. Für die effiziente Kühlung solcher Module, wird meist Wasser bzw. Wasser/Glykol verwendet. Die dazu verwendeten Kühler werden - vergleichbar zu der in der US-A-4,574,877 beschriebenen Konfiguration - mit den Modulen in einem mit Druck beaufschlagten Stapel in Serie geschaltet und befinden sich demnach ebenfalls auf hohen Potentialen. Die Kühler müssen mit deionisiertem Wasser betrieben werden, da ansonsten Strom über das Kühlmedium zu niedrigeren Potentialen fliessen könnte. Durch die Anforderung, solche Module in Serie schalten zu können, werden diese dermassen konstruiert, dass die eine Stirnfläche dem Emitterpotential und die gegenüberliegende Fläche dem Kollektorpotential entsprechen. Eine neuere Version eines solchen Moduls, bei dem in einer "Press Pack"-Konfiguration mehrere IGBT-Chips innerhalb des Moduls parallelgeschaltet sind, ist in dem eingangs genannten Artikel von H. Zeller gezeigt und beschrieben. Die "Press Pack"-Konfiguration, bei der die elektrische Verbindung zu den im Modul angeordneten Halbleiterchips durch Druckkontakt hergestellt wird, hat gegenüber der Kontaktierung durch Bonddrähte den Vorteil, dass im Fehlerfall ein stabiler Kurzschluss im Modul vorliegt, so dass in einer Serieschaltung eine Unterbrechung des Stromflusses für diesen Fall vermieden wird.

Bei anderen Anwendungen (z.B. der Traktion) ist die Ausgangslage etwas anders: Hier wird mit niedrigeren Spannungen gearbeitet, so dass die direkte Serieschaltung der Module nicht notwendig ist. Andererseits darf aber kein deionisiertes Wasser verwendet werden, da dies in der Anwendung zu Komplikationen führen kann. Deswegen sollen solche Module gegen das Kühlmedium isoliert werden.

Typischerweise wird dies durch die Verwendung von AIN-Substraten innerhalb des Moduls, bzw. durch die Einführung von grossen AIN-Platten zwischen Halbleiter-Modul und Kühler erreicht. In gewissen Fällen wird sogar mit AIN-Kühlern gearbeitet. Solche isolierten Module haben leider oftmals eine beschränkte Zuverlässigkeit (thermische Ausdehnung zwischen Bodenplatte und Substraten), während die grossen AIN-Platten und -Kühler sehr teuer sind.

### DARSTELLUNG DER ERFINDUNG

Es ist daher Aufgabe der Erfindung, ein Hochleistungshalbleitermodul zu schaffen, welches die erhöhte Zuverlässigkeit von Druckkontakt-Modulen mit der Möglichkeit verbindet, einen brauchwasserdurchflossenen Kühler verwenden zu können, sowie eine Anwendung für ein solches Hochleistungshalbleitermodul anzugeben.

Die Aufgabe wird durch die Gesamtheit der Merkmale der Ansprüche 1 und 13 gelöst. Der Kern der Erfindung besteht darin, das Modul gleichzeitig in einer "Press Pack"-Konfiguration auszuführen und die Aussenseiten des Moduls von den im Modul untergebrachten Halbleiterchips elektrisch isoliert auszubilden. Auf diese Weise wird bei gleichzeitig zuverlässiger Kontaktgabe eine Potentialtrennung zu einer aussen anliegenden Kühlvorrichtung erreicht.

Eine bevorzugte Ausgestaltung der Erfindung zeichnet sich dadurch aus, dass zwischen der Oberseite der Halbleiterchips und der Deckplatte jeweils ein erstes elektrisch leitendes, elastisches Verbindungselement, vorzugsweise in Form einer ersten Kontaktfeder angeordnet ist, dass die Bodenplatte ein elektrisch isolierendes Substrat umfasst, welches auf der Innenseite eine erste Metallbeschichtung aufweist, dass die Halbleiterchips auf der ersten Metallbeschichtung stoffschlüssig befestigt, vorzugsweise aufgelötet sind, dass die erste Metallbeschichtung in einem ausserhalb der Halbleiterchips liegenden Bereich von der Deckplatte unter Herstellung eines dritten elektrischen Kontaktes mit Druck beaufschlagt wird, und dass der dritte elektrische Kontakt über ein zweites elektrisch leitendes, elastisches Verbindungselement, vorzugsweise in Form einer zweiten Kontaktfeder, vermittelt wird.

Eine bevorzugte Weiterbildung dieser Ausgestaltung ist dadurch gekennzeichnet, dass die Deckplatte eine erste Isolationsplatte umfasst, auf deren Innenseite eine erste metallische Kontaktplatte angeordnet ist, über welche die zweiten elektrischen Kontakte mit den Halbleiterchips hergestellt werden, und dass auf der ersten metallischen Kontaktplatte und von dieser elektrisch isoliert eine zweite metallische Kontaktplatte angeordnet ist, über welche der dritte elektrische Kontakt zur ersten Metallbeschichtung der Bodenplatte hergestellt wird.

Zum weiteren Schutz des Moduls ist zwischen der Bodenplatte und der Deckplatte ein elektrisch isolierendes Gehäuse angeordnet, welches die Halbleiterchips und die zugehörigen Kontakteinrichtungen umschliesst.

Weitere Ausführungsformen ergeben sich aus den abhängigen Ansprüchen.

### KURZE ERLÄUTERUNG DER FIGUREN

Die Erfindung soll nachfolgend anhand von Ausführungsbeispielen im Zusammenhang mit der Zeichnung näher erläutert werden. Es zeigen
- Fig. 1: in der Draufsicht von oben die Bodenplatte mit den Halbleiterchips und Kontaktfedern sowie dem umgebenden Gehäuse eines bevorzugten Ausführungsbeispiels der Erfindung;
- Fig. 2: im Längsschnitt die zu dem Modul aus Fig. 1 gehörende Deckplatte; und
- Fig. 3: im Längsschnitt das fertig montierte Modul gemäss Fig. 1 und 2 und seine Verwendung in einem Stapel mit einer Kühlvorrichtung.

### WEGE ZUR AUSFÜHRUNG DER ERFINDUNG

In Fig. 3 ist im Längsschnitt ein Hochleistungshalbleitermodul 10 gemäss einem bevorzugten Ausführungsbeispiel der Erfindung dargestellt. Das Modul umfasst eine Bodenplatte 11, auf deren Oberseite (Innenseite) gemäss Fig. 1 einen Mehrzahl von (im Beispiel insgesamt 12) Halbleiterchips 14 in einer regulären Anordnung von vier Reihen zu je drei Chips angebracht sind. Um die Halbleiterchips 14 herum ist randseitig ein elektrisch isolierendes Gehäuse 12 (vorzugsweise aus Kunststoff) vorgesehen, dass durch geeignete Massnahmen (z.B. eine Querwellung) in vertikaler Richtung zusammengedrückt werden kann. Das Hochleistungshalbleitermodul 10 wird oben durch eine Deckplatte 13 abgeschlossen (siehe auch Fig. 2). Zwischen der Deckplatte 13 und den freien Oberseiten der Halbleiterchips 14 sind erste Kontaktfedern 15 angeordnet, über die (bei entsprechendem Druck) ein elektrischer Kontakt zwischen Deckplatte 13 und Halbleiterchips 14 hergestellt wird. Zweite Kontaktfedern 16, die zwischen den beiden Sechsergruppen der Halbleiterchips 14 plaziert sind, geben einen entsprechenden Druckkontakt zwischen der Deckplatte 13 und der Bodenplatte 11.

Als Bodenplatte 11 wird ein elektrisch isolierendes Substrat 17 (z.B. AIN oder einer anderen Keramik) verwendet, welches auf der Ober- und Unterseite jeweils mit einer Metallbeschichtung 19 bzw. 18 versehen ist. Auf die obere Metallbeschichtung 19 der Bodenplatte 11 werden die Halbleiterchips 14 gelötet, wobei Platz für die zweiten Kontaktfedern 16 gelassen wird. Handelt es sich bei den Halbleiterchips 14 z.B. um IGBTs, werden diese mit der Kollektorseite aufgelötet. Die Emittermetallisierung jedes Halbleiterchips 14 wird nun mit einem gefederten Kontakt (erste Kontaktfeder 15) bestückt. Die Kontaktfedern 15, die im dargestellten Beispiel topfförmig ausgebildet sind, können die unterschiedlichsten Formen annehmen, sofern der Federdruck ausreichend gross ist und die Kontaktflächen für die vorgegebenen hohen Ströme ausreichen. Die freien Flächen der oberen Metallbeschichtung 19 werden mit vergleichbaren zweiten Kontaktfedern 16 versehen. Im dargestellten Beispiel sind so die mittleren drei Kontaktfedern 16 auf Kollektorpotential und die äusseren zwölf Kontaktfedern 15 (der Halbleiterchips 14) auf Emitterpotential. Diese beiden Potentiale bzw. Spannungen können nun von oben mittels der Deckplatte 13 abgegriffen werden.

Die Deckplatte 13 hat eine Sandwichstruktur (Fig. 2): Eine schmale Kollektor-Kontaktplatte 23 (Kollektor-Busbar) ist - durch eine Isolationsplatte 22 isoliert - auf eine grossflächige Emitter-Kontaktplatte 21 (Emitter-Busbar) geklebt. Die Emitter-Kontaktplatte 21 ihrerseits ist mit Hilfe einer weiteren Isolationsplatte 20 gegen Aussen isoliert. Die Kollektor-Kontaktplatte 23 drückt auf die mittleren Kontaktfedern 16 und steht so über die obere Metallbeschichtung in Kontakt mit der Kollektorseite der Halbleiterchips 14. Die Emitter-Kontaktplatte 21 drückt auf die auf den Halbleiterchips 14 angeordneten Kontaktfedern 15 und steht so in Kontakt zu der Emitterseite der Halbleiterchips 14. Von beiden Kontaktplatten 21 und 23 können entsprechend angeformte Kontaktfahnen seitlich aus dem Gehäuse 12 herausgeführt und als elektrische Anschlüsse des Moduls verwendet werden.

Das dargestellte Hochleistungshalbleitermodul 10 kann gemäss Fig. 3 nun in einer Pressvorrichtung gestapelt werden, wobei nur die Bodenplatte 11 gekühlt werden muss. Hierzu wird eine (in Fig. 3 gestrichelt eingezeichnete) Kühlvorrichtung 24 eingesetzt, die mit einer Kühlfläche an der unteren Metallbeschichtung 18 der Bodenplatte 11 anliegt. Durch einen von beiden Seiten auf den Stapel ausgeübten Druck (Pfeile in Fig. 3) werden sowohl die elektrischen Druckkontakte im Inneren des Moduls gewährleistet als auch der thermische Kontakt zwischen Bodenplatte 11 und Kühlvorrichtung 24. Als Kühlvorrichtung 24 kommt beispielsweise eine an sich bekannte, von Wasser durchflossene Kühldose in Betracht.

### BEZUGSZEICHENLISTE

- 10: Hochleistungshalbleitermodul
- 11: Bodenplatte
- 12: Gehäuse (elektrisch isolierend)
- 13: Deckplatte
- 14: Halbleiterchip
- 15,16: Kontaktfeder
- 17: Substrat (elektrisch isolierend)
- 18,19: Metallbeschichtung
- 20,22: Isolationsplatte
- 21: Kontaktplatte (Emitter)
- 23: Kontaktplatte (Kollektor)
- 24: Kühlvorrichtung

## Patentansprüche

1. Hochleistungshalbleitermodul (10), bei welchem mehrere flächige Halbleiterchips (14) mit der Unterseite unter Herstellung erster elektrischer Kontakte flächig auf einer Bodenplatte (11) aufliegen und auf der Oberseite von einer parallel zur Bodenplatte (11) angeordneten Deckplatte (13) unter Herstellung zweiter elektrischer Kontakte mit Druck beaufschlagt werden, **dadurch gekennzeichnet, dass** die den Halbleiterchips (14) abgewandten Seiten bzw. Aussenseiten der Bodenplatte (11) und der Deckplatte (13) jeweils von den Halbleiterchips (14) elektrisch isoliert ausgebildet sind.

2. Hochleistungshalbleitermodul nach Anspruch 1, **dadurch gekennzeichnet, dass** zwischen der Oberseite der Halbleiterchips (14) und der Deckplatte (13) jeweils ein erstes elektrisch leitendes, elastisches Verbindungselement, vorzugsweise in Form einer ersten Kontaktfeder (15) angeordnet ist.

3. Hochleistungshalbleitermodul nach einem der Ansprüche 1 und 2, **dadurch gekennzeichnet, dass** die Bodenplatte (11) ein elektrisch isolierendes Substrat (17) umfasst, welches auf der Innenseite eine erste Metallbeschichtung (19) aufweist, und dass die Halbleiterchips (14) auf der ersten Metallbeschichtung (19) stoffschlüssig befestigt, vorzugsweise aufgelötet sind.

4. Hochleistungshalbleitermodul nach Anspruch 3, **dadurch gekennzeichnet, dass** das Substrat (17) aus einer Keramik, vorzugsweise aus einer AIN-Keramik, besteht.

5. Hochleistungshalbleitermodul nach einem der Ansprüche 3 und 4, **dadurch gekennzeichnet, dass** die Bodenplatte (11) auf der Aussenseite mit einer zweiten Metallbeschichtung (18) versehen ist.

6. Hochleistungshalbleitermodul nach einem der Ansprüche 3 bis 5, **dadurch gekennzeichnet, dass** die erste Metallbeschichtung (19) in einem ausserhalb der Halbleiterchips (14) liegenden Bereich von der Deckplatte (13) unter Herstellung eines dritten elektrischen Kontaktes mit Druck beaufschlagt wird.

7. Hochleistungshalbleitermodul nach Anspruch 6, **dadurch gekennzeichnet, dass** der dritte elektrische Kontakt über ein zweites elektrisch leitendes, elastisches Verbindungselement, vorzugsweise in Form einer zweiten Kontaktfeder (16), vermittelt wird.

8. Hochleistungshalbleitermodul nach einem der Ansprüche 6 und 7, **dadurch gekennzeichnet, dass** die Deckplatte (13) eine erste Isolationsplatte (20) umfasst, auf deren Innenseite eine erste metallische Kontaktplatte (21) angeordnet ist, über welche die zweiten elektrischen Kontakte mit den Halbleiterchips (14) hergestellt werden, und dass auf der ersten metallischen Kontaktplatte (21) und von dieser elektrisch isoliert eine zweite metallische Kontaktplatte (23) angeordnet ist, über welche der dritte elektrische Kontakt zur ersten Metallbeschichtung (19) der Bodenplatte (11) hergestellt wird.

9. Hochleistungshalbleitermodul nach Anspruch 8, **dadurch gekennzeichnet, dass** die erste und zweite metallische Kontaktplatte (21 bzw. 23) durch eine zweite Isolationsplatte (22) voneinander isoliert sind.

10. Hochleistungshalbleitermodul nach einem der Ansprüche 1 bis 9, **dadurch gekennzeichnet, dass** zwischen der Bodenplatte (11) und der Deckplatte (13) ein elektrisch isolierendes Gehäuse (12) angeordnet ist, welches die Halbleiterchips (14) und die zugehörigen Kontakteinrichtungen (15, 16) umschliesst.

11. Hochleistungshalbleitermodul nach einem der Ansprüche 1 bis 10, **dadurch gekennzeichnet, dass** die Halbleiterchips (14) innerhalb des Hochleistungshalbleitermoduls (10) elektrisch parallelgeschaltet sind.

12. Hochleistungshalbleitermodul nach Anspruch 11, **dadurch gekennzeichnet, dass** zumindest ein Teil der Halbleiterchips (14) steuerbare Halbleiterschalter, insbesondere IGBTs, sind.

13. Anwendung eines Hochleistungshalbleitermoduls nach einem der Ansprüche 1 bis 12 in einer leistungselektronischen Anlage, in welcher das Hochleistungshalbleitermodul (10) zusammen mit einer auf der Aussenseite der Bodenplatte (11) angrenzenden Kühlvorrichtung (24) zu einem Stapel angeordnet und in dem Stapel mit Druck beaufschlagt wird.
